# EUROPEAN PATENT APPLICATION

(11) **EP 2 472 532 A1**
(43) Date of publication of application: **04.07.2012**
(21) Application number: 11150138.3
(22) Date of filing: 04.01.2011
(51) Int. Cl.: H01F 6/06, H01L 39/16, H02H 9/02

(54) **Coil, coil assembly and superconducting fault current limiter**

(71) Applicant: Applied Superconductor Ltd., Blyth Northumberland NE24 3AG (GB)
(72) Inventor: The designation of the inventor has not yet been filed
(74) Representative: Vinsome, Rex Martin

(57) **Abstract**

A coil (12, 112, 212) is described, the coil (12, 112, 212) comprising an electrically conducting element (18, 118, 218) defining a plurality of first turns (20, 120, 220) around a first axis (X1, X101, X201), wherein at least two first turns are adapted to carry a current in opposite senses around the first axis (X1, X101, X201); and a respective plurality of second turns (22, 122, 221, 222) around at least one second axis (X2, X102, X202, X203), wherein at least two second turns are adapted to carry a current in opposite senses around a respective second axis (X2, X102, X202, X203); wherein at least two first turns are connected in series via at least one second turn. A superconducting fault current limiter (400) is described, comprising a coil (12, 112, 212) as described above, the conducting element (18, 118, 218) of which comprises a superconducting material.

## Description

### FIELD OF THE INVENTION

This invention relates to a coil, and relates particularly, but not exclusively, to a superconducting coil and a superconducting fault current limiter comprising a superconducting coil or coils.

### BACKGROUND OF THE INVENTION

A superconducting fault current limiter comprises a cryostat containing at least one superconducting component connected at both ends to bushings which pass through the cryostat enclosure. Superconducting fault current limiters have been used in electricity supply networks, which are normally expected to carry currents of a few hundred amperes, but, if a short circuit (fault) occurs, the current can rise to levels which can be several tens of thousands of amperes. When a fault occurs in a network protected by a resistive superconducting fault limiter, the current density in the superconducting material exceeds the critical current density of the material, which ceases to be superconducting and becomes resistive. This process is known as quenching. The presence of this additional resistance in the circuit causes the current to be reduced, or "limited", reducing the potentially damaging effects of excessively high currents in the network.

A particular application of superconducting fault current limiters is for connecting power generators, such as wind turbines, to a grid.

The superconducting component of a superconducting fault current limiter comprises a superconducting wire or tape. The superconducting component may be tens or hundreds of metres long, depending on the application. To make a superconducting fault current limiter as compact as possible, the superconducting component should occupy as small a volume as possible, so as to accommodate the maximum possible length of wire or tape in the available volume. This is achieved by winding the superconducting component. However, superconducting materials are typically brittle and a superconducting wire or tape consequently has a minimum bend radius. Bending the material more sharply than the minimum bend radius may cause the material to be damaged.

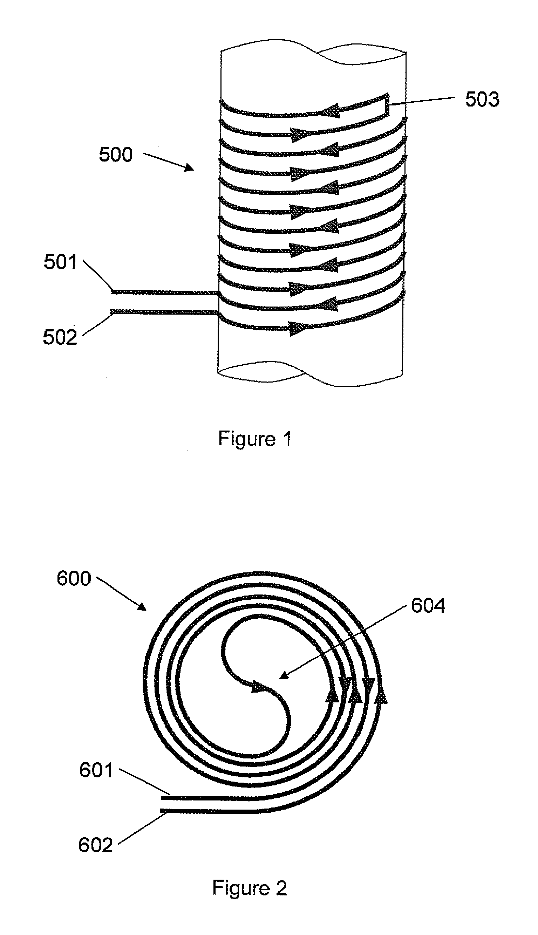

To minimise thermal losses in a superconducting fault current limiter it is necessary to minimise the a.c. losses associated with the superconducting component. This is greatly assisted by minimising the inductance of the winding, which is typically achieved by arranging the winding to be bifilar, such that current flow is in opposing directions in adjacent turns. This can be achieved by arranging the turns in a helical bifilar coil 500, as shown in Figure 1, or in a flat spiral "pancake" bifilar coil 600 as shown in Figure 2.

A significant disadvantage associated with these bifilar coil arrangements is that all of the voltage applied across the coil 500, 600 appears between the two adjacent turns 501, 502, 601, 602 at the end of the coil 500, 600 closest to its terminals. In typical superconducting fault current limiter applications, this voltage may be of the order of tens of thousands of volts under fault conditions, such as, for example, a lightening strike. It is desirable that a superconducting fault current limiter uses as few coils as possible, in order to minimise the thermal losses associated with the connections between superconducting components. Therefore, preferably only one winding per phase is used, which means that all of the voltage applied to the fault current limiter appears between adjacent turns of a winding.

This has an impact on the size of the coil because the spacing between adjacent turns of the bifilar coil, in particular between the turns of the coil at the end closest to the terminals, must be sufficient to isolate neighbouring turns from each other under these conditions. This increases the overall length of the bifilar coil, thereby increasing the cost of cooling the coil below the superconductors critical temperature.

A further disadvantage associated with the bifilar coil arrangements is that the superconducting wire or tape must change direction at one end of coil. However, the radius of curvature of the superconducting wire or tape cannot be smaller than the minimum bend radius of the material. In the helical bifilar coil 500 shown in Figure 1, a connecting element 503 is used to join the two counter-wound strands of the bifilar coil 500 together at one end of the coil, so that the overall size of the coil is not increased. However, this connecting element comprises non-superconducting material, the resistivity of which leads to an increase in thermal losses. In the spiral bifilar coil 600 shown in Figure 2, the radius of curvature of the coil is increased to accommodate an S-shaped loop 604 between the two counter-wound parts of the bifilar coil, increasing the overall size of the coil.

Preferred embodiments of the present invention seek to overcome one or more of the above disadvantages of the prior art.

### SUMMARY OF THE INVENTION

According to the present invention, there is provided a coil comprising an electrically conducting element defining:
a plurality of first turns around a first axis,
   wherein at least two said first turns are adapted to carry a current in opposite senses around the first axis; and
a respective plurality of second turns around at least one second axis,
   wherein at least two said second turns are adapted to carry a current in opposite senses around a respective said second axis;
wherein at least two said first turns are connected in series via at least one second turn.

Arranging at least two of the first turns to carry a current in opposite senses around the first axis, and at least two of the second turns to carry a current in opposite senses around a respective said second axis, enables each of the plurality of first turns and the plurality of second turn to have a low inductance.

Advantageously, winding the coil as a plurality of first turns about a first axis, and at least one plurality of second turns about a respective second axis, wherein at least two said first turns are connected in series via at least one second turn, enables the sense of the turns around any one axis to be reversed from one turn to the next adjacent turn.

In this way, a low-inductance coil can be obtained using a monofilar winding. By monofilar, we mean that the conducting element does not double back upon itself as in a bifilar winding. In contrast to a bifilar coil, the maximum voltage drop between neighbouring turns of a monofilar coil is always a fraction of the voltage drop across the entire coil, and may be approximately equal to the total applied voltage divided by the number of turns around each axis for example. Adjacent turns can therefore be spaced by a distance which is significantly smaller than the distance permissible between adjacent turns close to the terminals of an equivalent bifilar winding.

A further advantage is that the coil of the present invention can be configured as a relatively compact, low-inductance coil, as the conducting element may have a radius of curvature close to its minimum permissible magnitude along most of its length. In contrast, the turns of the bifilar spiral coil shown in Figure 2 are wound at a radius of curvature greater than the minimum, in order to accommodate the change of direction at the centre of the coil. The bifilar helical coil shown in Figure 1 may be wound close to the minimum possible radius of curvature only if a non-superconducting connection is made between the two strands of the bifilar coil.

Yet another advantage of the present invention is that, by winding the coil around at least two axes, rather than as a single helical coil, the length of the coil is significantly reduced. For example, when two axes are used, the length of the coil may be approximately halved. When the coil is wound around more than two axes, greater reductions in length are achieved. This enables the shape of the coil to be adapted to different applications.

Preferably, the ends of the conducting element are located at or extend from locations spaced apart along at least one said first or second axis.

Advantageously, this prevents the full voltage applied across the coil from appearing between two adjacent turns of the coil. This may be achieved by winding the coil of the present invention as a monofilar coil, such that the ends of the conducting element extend from opposite ends of the coil.

Preferably, the conducting element comprises at least one super-conducting material.

Preferably, at least one first turn is connected to at least one second turn by a portion of the conducting element having a radius of curvature substantially equal in magnitude to a radius of curvature of said first and/or second turn.

Advantageously, this feature enables the magnitude of the radius of curvature to be substantially constant along the entire length of the coiled part of the conducting element, for example at a value close to the minimum radius of curvature of the conducting element. This may be useful in minimising the volume occupied by the conducting element.

Preferably, at least one said plurality of first and/or second turns comprises a plurality of pairs of adjacent said first or second turns adapted to carry said current in opposite senses.

This reduces the electromagnetic forces between adjacent turns, and is particularly advantageous in high-current applications.

Preferably, at least one said plurality of first and/or second turns comprises an equal number of turns in each sense about the respective first and/or second axis.

This helps to minimise the overall inductance of the respective plurality of turns. More preferably, each plurality of turns comprises an equal number of turns in each sense.

Preferably, said first axis and at least one said second axis are substantially parallel.

In one embodiment, the conducting element is wound in a figure-of-eight type pattern around the first axis and one second axis.

Preferably, a plurality said first and/or second turns have a substantially constant radius of curvature.

A plurality of said first and said second turns may have a first radius of curvature and a plurality of said first and said second turns may be arranged radially inward of the periphery of a circle having a second radius of curvature, larger than said first radius of curvature, and at least three said turns may be arranged at separate locations radially outwards of the periphery of said circle.

This provides the advantage of enabling a very high packing density of conductive element to be achieved, for example by enabling three turns arranged radially outwards of the circle to define a triangle, enabling convenient arrangement of turns of three separate phases in a cylindrical tank of coolant liquid.

According to another aspect of the invention, there is provided a coil assembly, comprising:
a coil as defined above; and
a plurality of formers;
wherein each said plurality of first or second turns is wound on a respective former.

In one embodiment, the coil assembly further comprises one or more supports for constraining the path of the conducting element between two or more formers.

Advantageously, one or more supports may be used to help maintain a constant magnitude radius of curvature of the conducting element, or to control the path of the conducting element to minimise the inductance of the coil.

At least one said support may include a support portion for engaging the conducting element and having a radius of curvature substantially equal to that of at least one said first and/or said second turn.

According to another aspect of the invention, there is provided a superconducting fault current limiter, comprising:
at least one coil as defined above, wherein the conducting element comprises a superconducting material; and
at least one vessel adapted to enclose said superconducting element at a temperature below the critical temperature of the superconducting material.

### BRIEF DESCRIPTION OF THE DRAWINGS

A preferred embodiment of the present invention will now be described, by way of example only and not in any limitative sense, with reference to the accompanying drawings, in which:
Figure 1 shows a prior art bifilar helical winding;
Figure 2 shows a prior art bifilar spiral winding;
Figures 3a and 3b illustrate a winding pattern for a coil according to a first embodiment of the present invention, and show two alternative arrangements for making connections to the coil;
Figures 4a to 4h illustrate the winding pattern for a coil according to the first embodiment;
Figures 5a and 5b illustrate two alternative arrangements for the exit path of the conducting element of a coil according to the first embodiment;
Figure 6 shows an arrangement of formers and supports for winding a coil according to the first embodiment;
Figures 7a to 7c illustrate a calculation of the length of the conducting element of one layer of the coil of the first embodiment;
Figure 8 illustrates a winding arrangement for a coil according to a second embodiment of the present invention;
Figures 9a to 9d illustrate a winding pattern for a coil according to the second embodiment;
Figure 10 illustrates a winding arrangement for a coil according to a third embodiment of the present invention;
Figures 11a to 11d illustrate the winding pattern for a coil according to the third embodiment;
Figure 12 illustrates a superconducting fault current limiter according to the fourth embodiment;
Figures 13a to 13d show a winding arrangement of a fifth embodiment of the invention;
Figure 14 shows a winding arrangement of a sixth embodiment of the invention; and
Figure 15 shows the arrangement of the windings of Figures 13a to 13d or Figure 14 in a superconducting fault current limiter.

### DETAILED DESCRIPTION OF THE EMBODIMENTS

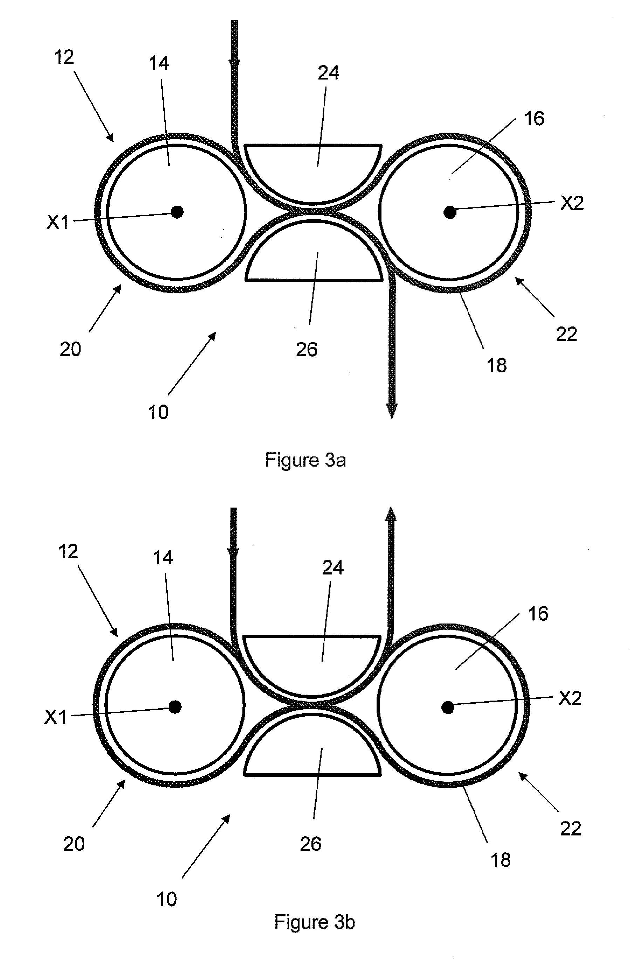

A first embodiment of the invention will be described with reference to Figure 3a, Figures 4a to 4h, and Figure 5a. Figure 3a shows a low-inductance coil assembly 10 comprising a coil 12, two cylindrical formers 14, 16, and two hemi-cylindrical supports 24, 26. The coil 12 comprises a conducting element 18, in the form of a conducting wire or tape, for example a superconducting wire or tape. The conducting element 18 defines a first subcoil 20 comprising a plurality of turns around a first axis X1, and a second subcoil 22 comprising a plurality of turns around a second axis X2, each plurality of turns being distributed along the length of the respective subcoil 20, 22. The two subcoils 20, 22 have substantially parallel axes X1, X2. The turns of each subcoil 20, 22 are arranged such that, when a current flows in the conducting element 18, adjacent turns of each subcoil 20, 22 carry the current in opposite senses about the respective axis X1, X2.

As will be explained in detail below, adjacent pairs of turns of the first subcoil 20 are connected in series via at least one turn of the second subcoil 22. In other words, the conducting element 18 comprises a plurality of first portions which contribute to the first subcoil 20, and a plurality of second portions which contribute to the second subcoil 22, such that the first and second portions alternate along the length of the conducting element 18. In the present embodiment, this is achieved by a figure-of-eight type winding pattern, in which each layer of the figure-of-eight is wound in an opposite sense.

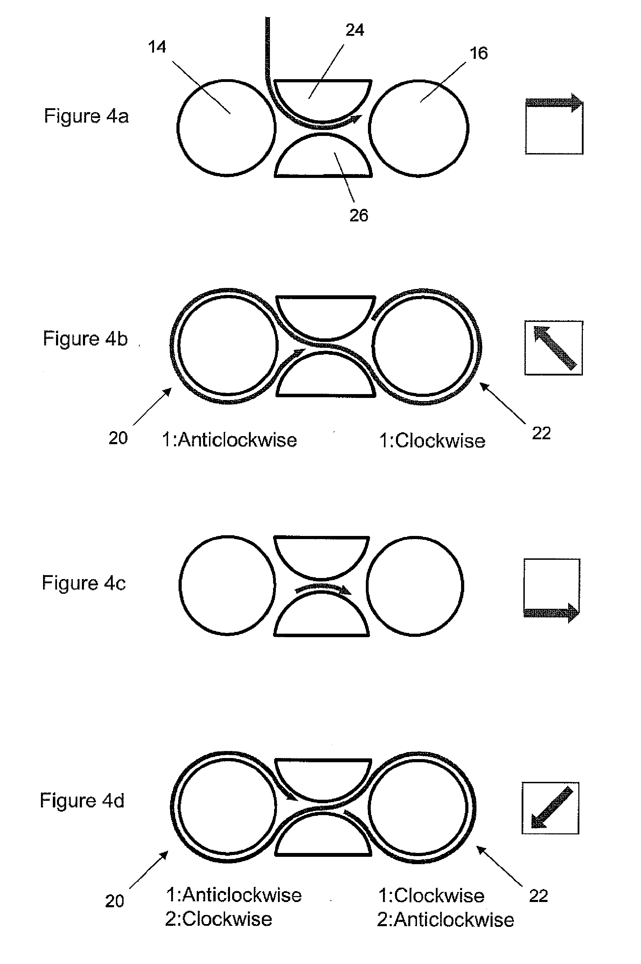

Figures 4a to 4h illustrate the winding arrangement of the coil 12 according to the first embodiment. Each successive turn on each of the two formers 14, 16 is in the direction opposite to that of the previous turn on the same former 14, 16. This causes cancellation of the magnetic field generated by a current flowing in adjacent turns, resulting in the arrangement having low inductance. Having each subsequent turn in the opposite direction to the previous turn also results in the most even distribution of electromagnetically generated force between the turns.

Figure 4a shows the point of entry of the conducting element 18 to the coil 12, and its route around support 24. Figure 4b shows the subsequent route of the conducting element as it passes clockwise around former 16, passes between the supports 24, 26 and then passes anticlockwise around former 14. Figure 4c shows the route of conducting element 18 around support 26 and Figure 4d shows the subsequent route of the conducting element as it passes anticlockwise around former 16, passes between the supports 24, 26 and then passes clockwise around former 14.

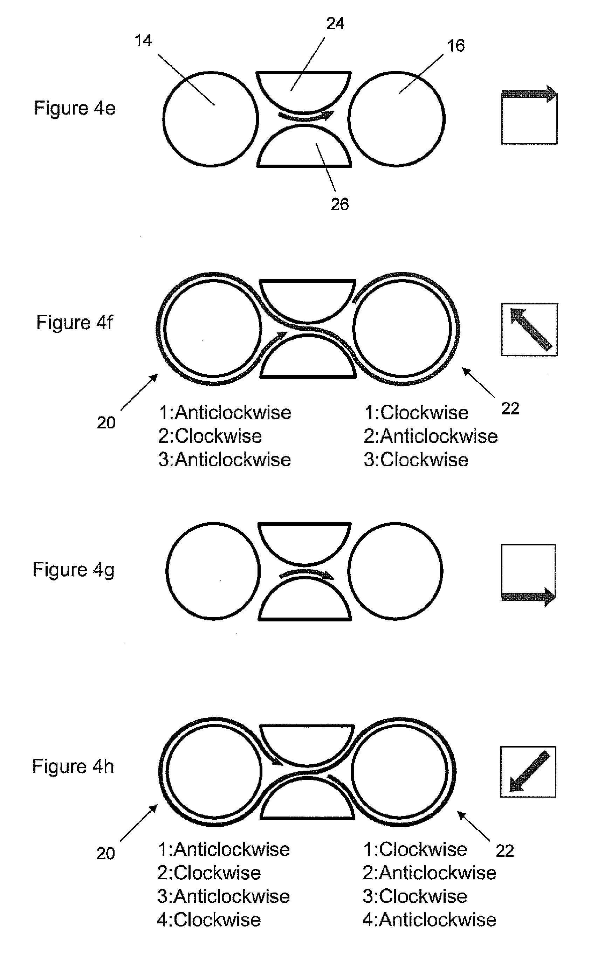

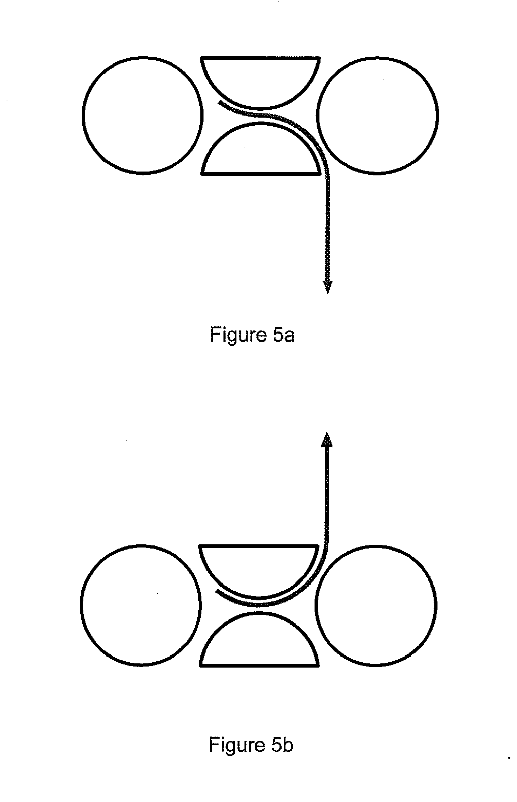

Thus Figures 4a to 4d illustrate the first two layers of the winding pattern. The next two layers of the winding pattern are illustrated by Figures 4e to 4h. The winding pattern can continue in this manner for as many layers as required, depending on the length of conducting element 18 to be accommodated, or the length of coil 12 desired. It is preferred that the coil 12 comprises an even number of complete layers, such that each subcoil 20, 22 comprises an equal number of turns in each sense in order to minimise the inductance of the coil 12. Once the required number of layers of the winding pattern have been completed, the conducting element 18 exits the coil 12 as shown in Figure 5a.

The turns around former 14 form a first subcoil 20, and the turns around former 16 form a second subcoil 22. If we consider the turns of the first subcoil 20, we can see that the first, second, third and fourth turns of subcoil 20 are anticlockwise, clockwise, anticlockwise, and clockwise respectively. Therefore, a current flowing through the conducting element will flow in opposite senses through adjacent turns of the first subcoil 20. This results in cancellation of the magnetic field created by current in the turns, and thus a low inductance. Similarly, if we consider the turns of the second subcoil 22, we can see that the first, second, third and fourth turns of subcoil 22 are, clockwise, anticlockwise, clockwise and anticlockwise respectively, such that the net magnetic field and inductance of the second subcoil 22 is also close to zero.

When the conducting element 18 enters and exits the coil 12 as shown in Figures 4a and 5a respectively, the ends of the conducting element 18 emerging from the coil 12 for electrical connection will be on opposite sides of the coil assembly 10, as shown in Figure 3a. Alternatively, the conducting element 18 may exit the coil 12 as shown in Figure 5b, so that the ends of the conducting element 18 emerging from the coil 12 for electrical connection will be on the same sides of the coil assembly 10, as shown in Figure 3b. Nonetheless, in both alternatives, the ends of the conducting element 18 emerging from the coil 12 for electrical connection will emerge from longitudinally-opposite ends of the coil 12.

From the above description, it can be seen that the present invention enables two adjacent turns on any given subcoil to be wound in opposite senses, without needing to reverse the local direction of the conducting element at any point, by winding an intermediate portion of the conducting element around a second subcoil. Thus it is possible to realise a low-inductance coil using a monofilar winding, with the ends of the conducting element 18 emerging from opposite ends of the coil 12. Thus the voltage between adjacent turns of the coil 12 never exceeds the voltage drop associated with each layer of the coil 12 i.e. the applied voltage divided by the number of layers. This allows the turns of each subcoil to be spaced by an equal distance which is significantly smaller than the distance permissible in the section close to the terminals of a bifilar winding. This in turn allows a greater length of the conducting element 18 to be accommodated in a given volume.

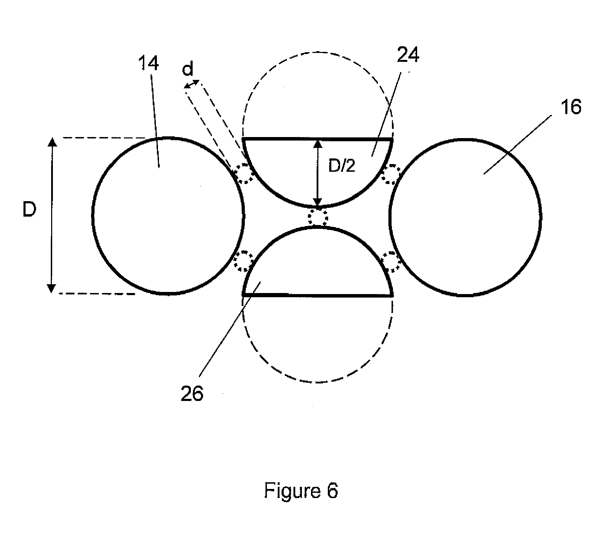

In the first embodiment, the conducting element 18 is wound around formers 14, 16 and supports 24, 26, arranged as shown in Figure 6. The formers 14, 16 and supports 24, 25 have parallel axes, and are cylindrical/hemi-cylindrical respectively, and all have the same radius D/2. The supports 24 and 25 are spaced apart by a distance slightly greater than the diameter d of the conducting element 18. The formers 14, 16 are spaced apart from the supports 24, 25 by a similar distance. In this arrangement, the conducting element 18 is bent at a constant bend radius along the entire length of the coiled part of the conducting element, which can be close to or greater than the minimum bend radius allowable for the particular conducting element 18. By "bend radius", the magnitude of the radius of curvature is meant.

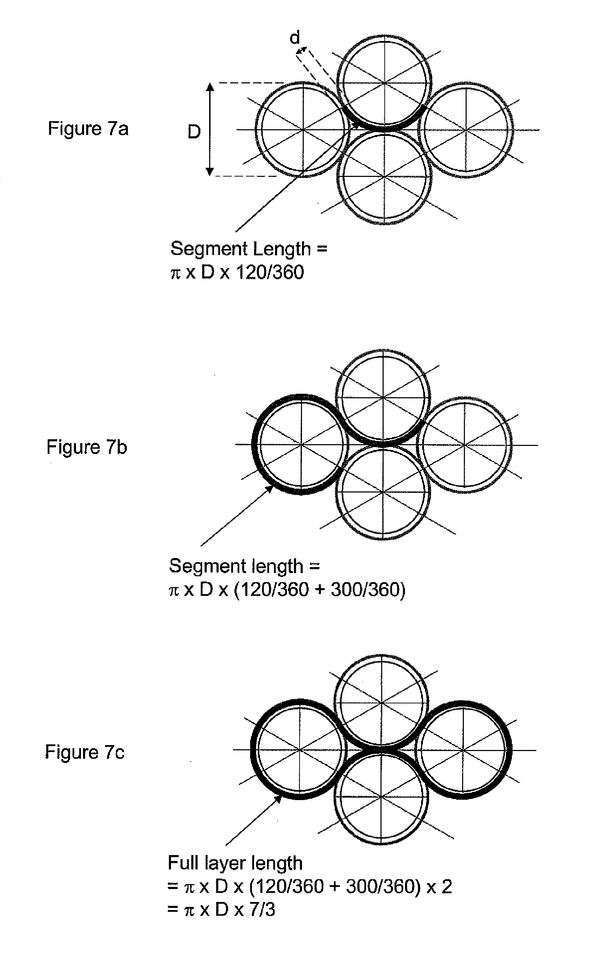

Figures 7a to 7c illustrate how the length of conducting element 18 occupying each layer of the coil 12 can be determined as a function of the diameter D of the formers 14, 16 and supports 24, 26. The segment of the conducting element 18 highlighted in Figure 7a has a length π*D*120/360. The segment highlighted in Figure 7b has a length π*D*(120/360 + 300/360). Thus the complete layer of the winding pattern highlighted in Figure 7c has a length 2*π*D*(120/360 + 300/360) = π*D*7/3. Thus eight layers of this winding pattern, using formers 14, 16 and supports 24, 26 having a diameter D of 205mm accommodates 12m of wire.

### [Example]

Measurements have been made on a (non-superconducting) coil according to the first embodiment described above, and compared with a simple helical coil and a bifilar helical coil, each comprising the same length of conducting element.

A traditional single helical coil (i.e. a monofilar helical coil), a bifilar helical coil, and a coil according to the first embodiment described above were each wound from a 9.8m long insulated copper wire having a cross-section of 0.5mm².

Measurements were made using a Wayne-Kerr bridge from Tinsley Prism Instruments 6471 LCR Data Bridge (calibrated 2/4/2010, NAREC Asset NA40540, Serial Number 267826) on 15th April 2010.

The inductance of the traditional single helical coil was calculated to be 67µH and the resistance (assuming pure copper, precisely 0.5mm², 9.8m, 20°C) was expected to be 0.33Ω. At 100Hz test frequency, the traditional single helical coil was determined to have 0.369Ω pure resistance and 73.3µH inductance, the resistance agreeing (to one significant figure) with a measurement made using an uncalibrated Fluke multi-meter.

At 100Hz test frequency, the bifilar helical coil was determined to have an inductance of 3.5µH.

At 100Hz test frequency, the low inductance coil wound as for the first embodiment described above, was determined to have 0.366Ω pure resistance and 4.1µH inductance, the resistance agreeing with a measurement made using the uncalibrated Fluke multi-meter.

Thus the inductance of the coil of the first embodiment is much lower than that of a traditional monofilar helical coil, and is comparable with that of a simple bifilar helical coil made from an identical length of conductor.

### [Second embodiment]

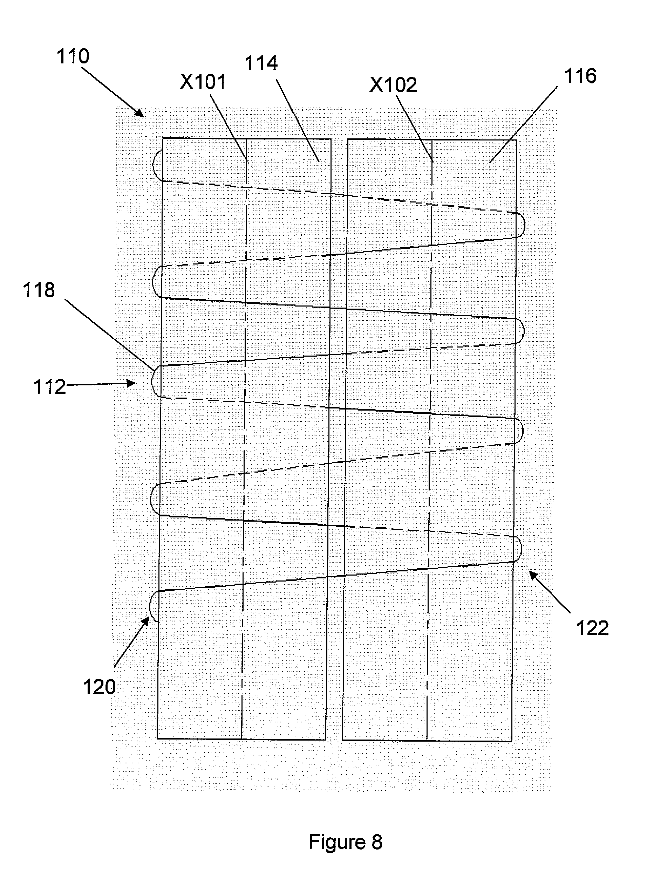

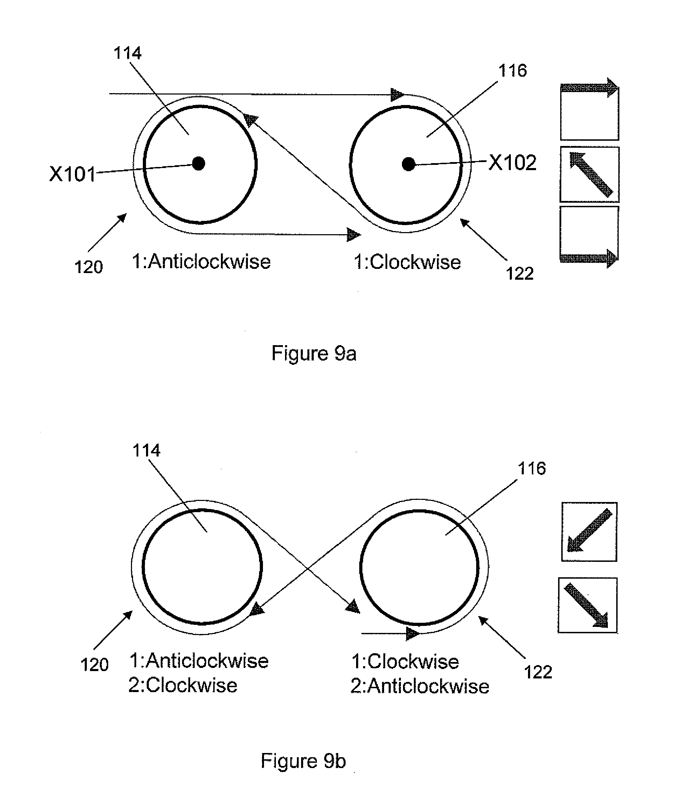

A second embodiment of the invention will be described with reference to Figures 8 and 9a to 9d. Figure 8 shows a low-inductance coil assembly 110 comprising a coil 112 and two cylindrical formers 114, 116. The coil assembly 110 may also include supports (not shown) arranged in a similar manner to the supports 24, 26 of the first embodiment. The coil 112 comprises a conducting element 118, in the form of a conducting wire or tape, for example a superconducting wire or tape. The conducting element 118 defines a first subcoil 120 comprising a plurality of turns about a first axis X101 and a second subcoil 122 comprising a plurality of turns about a second axis X102, each plurality of turns being distributed along the length of the respective subcoil 120, 122. The turns of each subcoil 120, 122 are arranged such that, when a current flows in the conducting element 118, neighbouring groups of turns of each subcoil 120, 122 carry the current in opposite senses about the respective axis X101, X102. In Figure 8, the conducting element 118 is indicated as a dotted line where it passes behind one of the formers 114, 116. The conducting element 118 comprises alternating first and second portions, the first portions contributing to a first subcoil 120, and the second portions contributing to a second subcoil 122. In this way, at least two turns of the first subcoil 120 are connected in series via at least one turn of the second subcoil 122. This is achieved by a figure-of-eight type winding pattern, which is different from that of the first embodiment, as will be illustrated by Figures 9a to 9d.

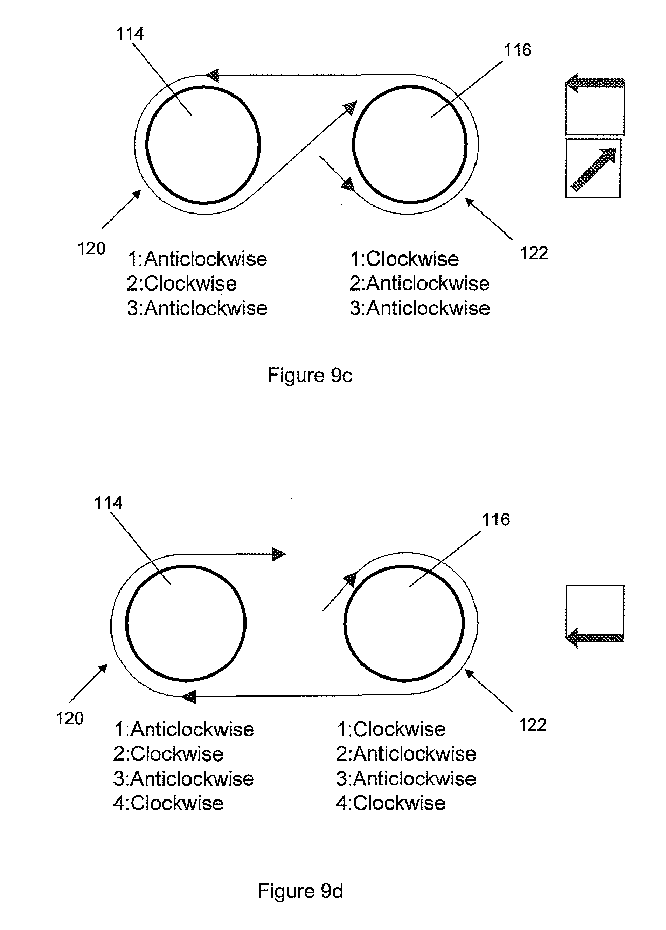

Figure 9a shows the point of entry of the conducting element 118 to the coil 110, and its route as it passes clockwise around former 116, crosses between the formers 114 and 116, and then passes anticlockwise around former 114, thereby completing the first layer of the winding pattern. Figure 9b shows the second layer of the winding pattern, as the conducting element 118 passes anticlockwise around former 116, crosses between the formers 114 and 116 and then passes clockwise around former 114. These first two layers are the same as the first two layers of the winding pattern of the first embodiment, but the next two layers are different. Figure 9c shows the third layer of the winding pattern, as the conducting element 118 passes anticlockwise around former 116, and then anticlockwise around former 114. Figure 9d shows the fourth layer of the winding pattern, as the conducting element 118 passes clockwise around former 116, and then clockwise around former 114. The pattern then repeats according to Figures 9a to 9d as many times as required. Again, it is preferred that the coil 112 comprises an even number of layers, so that each subcoil 120, 122 comprises an equal number of turns in each sense in order to minimise the inductance of the coil 112.

In the second embodiment, the first, second, third and fourth turns of the first subcoil 120 are anticlockwise, clockwise, anticlockwise, and clockwise respectively, the same as in the first embodiment. Therefore, a current flowing through the conducting element will flow in opposite senses in all pairs of adjacent turns of the first subcoil 120. However, the first, second, third and fourth turns of the second subcoil 122 are, clockwise, anticlockwise, anticlockwise and clockwise respectively. Thus, a current will flows in opposite senses through neighbouring groups of turns of the second subcoil 122, where each group includes two adjacent turns. The net magnetic field and inductance of the second subcoil 122 will also be close to zero, but the electromagnetic forces between the turns of the coil 112 of the second embodiment will be greater than for the first embodiment, due to the presence of pairs of adjacent turns carrying current in the same sense around the second subcoil 122.

For this reason, the first embodiment is preferred to the second embodiment. However, the second embodiment may be advantageous in that it provides better cancellation of the magnetic fields produced by the segments of the conducting element passing between the two formers 114 and 116. In Figures 4a to 4h, an arrow at the right hand side of each figure indicates the position and direction of a segment of conducting element 18 which passes between the two formers 14 and 16. It will be seen that these do not cancel out perfectly, as the segments of the conducting element 18 which pass "straight" from one former to the other (Figures 4a, c, e and g) always travel in the same direction, and the segments which "cross" between the two formers (Figures 4b, d, f and h) always travel generally from right to left. In contrast, the second embodiment may be advantageous in that the corresponding segments of the conducting element 118 are arranged to provide better magnetic field cancellation in the region between the two subcoils 120, 122. The paths followed by the segments of the conducting element 118 between the two subcoils 120, 122 are arranged so that the currents in these segments cancel out over four consecutive layers.

### [Third embodiment]

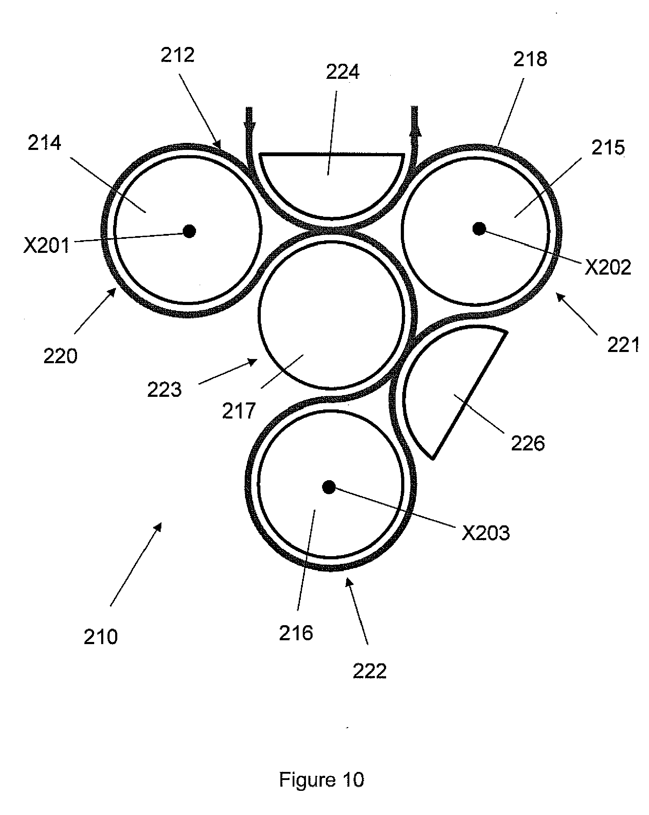

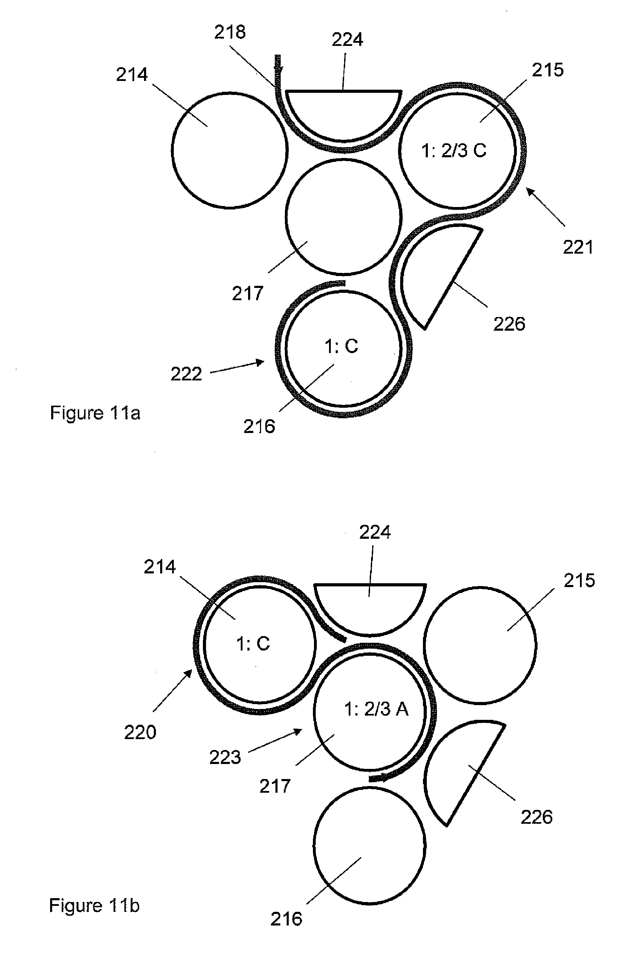

A third embodiment of the invention will be described with reference to Figures 10 and 11a to 11d. Figure 10 shows a low-inductance coil assembly 210 comprising a coil 212, three cylindrical formers 214, 215, 216, two hemi-cylindrical supports 224, 226 and a cylindrical support 217. The coil 212 comprises a conducting element 218, in the form of a conducting wire or tape, for example a superconducting wire or tape, formed into three subcoils 220, 221, 222 wound around formers 214, 215 and 216 respectively. The conducting element 218 defines a first subcoil 220 comprising a plurality of turns around a first axis X201, a second subcoil 221 comprising a plurality of turns around a second axis X202, and a third subcoil 222 comprising a plurality of turns around a third axis X203, the turns of each subcoil 220, 221, 222 being distributed along the length of the respective subcoil 220, 221, 222. The turns of each subcoil 220, 221, 222 are arranged such that, when a current flows in the conducting element 218, adjacent turns of each subcoil 220, 221, and 222 carry the current in opposite senses about the respective axis X201, X202, X203. As will be explained in detail below, the conducting element 218 comprises alternating first and second portions, the first portions contributing to a first subcoil 220, and the second portions contributing to a second and third subcoils 221, 222. In this way, adjacent pairs of turns around the first axis X201 are connected in series via turns around the second and third axes X202, X203. This is achieved by the winding pattern illustrated by Figures 11a to 11d.

Figures 11a and 11b show the first layer of the winding pattern. Figure 11a shows the point of entry of the conducting element 218 to the coil 212 and its route as it passes around support 224 and then performs two-thirds of a clockwise turn around formers 215 and a complete clockwise turn around former 216. Figure 11b shows the route of the conducting element 218 as it performs two-thirds of an anticlockwise turn around support 217, followed by a clockwise turn around former 214.

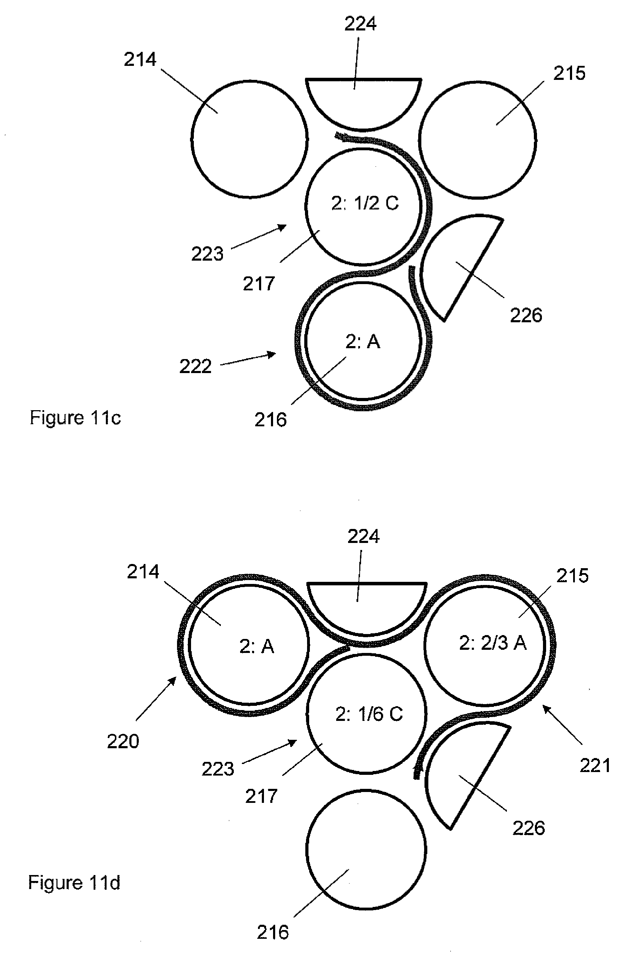

Figure 11c and 11d show the second layer of the winding pattern, as the conducting element 218 makes half a clockwise turn around support 217 and an anticlockwise turn around former 216 (Figure 11c), then two-thirds of an anticlockwise turn around former 215, an anticlockwise turn around former 214, and a sixth of a clockwise turn around support 217 (Figure 11d). The pattern then repeats according to Figures 11a to 11d as many times as required. Again, it is preferred that the coil 212 comprises an even number of layers, so that each subcoil 220, 221, 222 comprises an equal number of turns in each sense in order to minimise the inductance of the coil 212.

In the third embodiment, the turns around each of subcoils 220, 221, 222 alternate clockwise, anticlockwise, clockwise, anticlockwise, and so on. Therefore, a current flowing through the conducting element 218 will flow in opposite senses through adjacent turns of each of the subcoils 220, 221, 222. This results in cancellation of the magnetic field created by current in the turns of each subcoil 220, 221, 222, and thus a low inductance. It can also be seen that a partial subcoil 223 is formed by the partial turns around the cylindrical former 217. Adjacent turns around this partial subcoil 223 are also in opposite senses, alternating anticlockwise, clockwise, anticlockwise, clockwise, and so on. Thus the magnetic field created by current in the turns of the partial subcoil 223 is also substantially cancelled, resulting in a low inductance.

By winding the conducting element 18, 118 into two subcoils 20, 22, 120, 122, as in the first and second embodiments, the length of the coil 12, 112 is reduced as compared to a bifilar helical coil wound from an equivalent length of conducting element. By increasing the number of subcoils to three subcoils 220, 221, 222 (and a further partial subcoil 223) as in the third embodiment described above, the length of the coil 212 is reduced still further. Thus the present invention provides a means for adapting the length of the coil to different applications.

Although the first to third embodiments above are based on substantially cylindrical subcoils having the same diameter, and a coil may include subcoils having different or varying diameters. Also, the subcoils may have other shapes, for example elliptical, and a single coil may include subcoils having different shapes. Thus, the overall dimensions of the coil may be adapted for use in different applications. For example, when used in a superconducting fault current limiter, the length and cross-section of the coil may be adapted to increase the length of super-conducting element which may be accommodated in a given cryostat.

Arrangements which maintain the magnitude of the radius of curvature of the conducting element at a substantially constant value, as in the first to third embodiments, may be preferred, as this enables the conducting element to be wound at close to the minimum radius of curvature along its entire length, which may be useful in optimising the ratio of the length of the conducting element to the overall volume of the coil.

Although the above embodiments describe a coil assembly comprising a coil and various formers and supports, the coil may be used alone. Formers and/or supports may nonetheless be useful for winding the coil, even if they are removed subsequently.

### [Fourth embodiment]

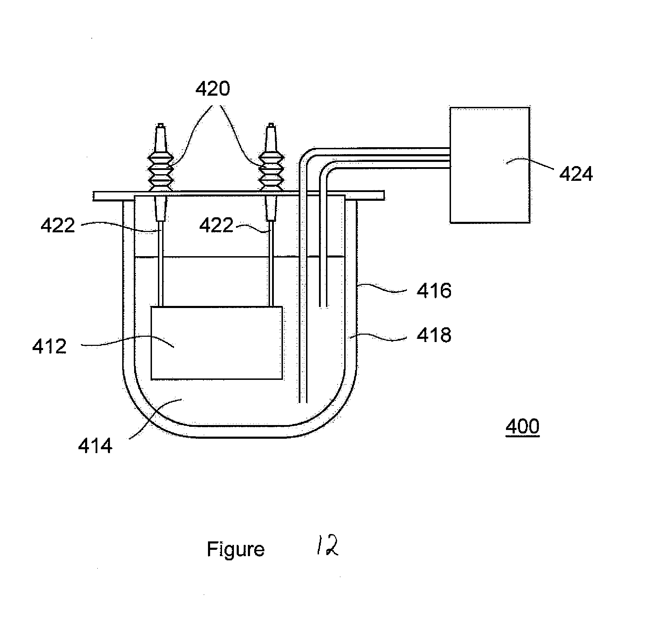

A fourth embodiment will be described with reference to Figure 12. Figure 12 shows a superconducting fault current limiter 410, comprising a current limiting component 412 in the form of one or more low-inductance coils 12, 112, 212 according to any one of the first to third embodiments described above, wherein the conducting element 18, 118, 218 comprises a super-conducting material, such as magnesium diboride wire. The current limiting component 412 is immersed in a liquid coolant (cryocoolant) 414 which is contained in a thermally insulated vessel 416. The thermal insulation of the vessel 416 is typically provided by a vacuum layer 418 surrounding the volume containing the cryocoolant 414. The vacuum-insulated vessel 416 is also sealed from the external atmosphere and is designed to withstand a predetermined change of the internal pressure. The vessel 416 may also be fitted with automatic pressure relief valves (not shown) because, in the event of a fault current, the "quenching" superconducting material of the current limiting component 412 generates sufficient heat to boil the cryocoolant 414 in its vicinity causing a pressure rise inside the vessel 416. Thermally insulated bushings 420 may be used to allow current leads 422 to pass into the vessel 416 causing minimal heat loss. A cooling machine 424 ensures that the cryocoolant 414 is kept at a sufficiently low temperature so that the superconducting parts of the current limiting component 412 maintain a superconducting state in the absence of fault current. Instead of a liquid cryocoolant 414, a solid or gaseous coolant may be used.

Advantageously, the low-inductance coils of the present invention enable a greater length of superconducting wire or tape to be accommodated in a cryostat of a given size, thereby reducing the costs of cooling the superconducting material to temperatures below the critical temperature of the material.

The superconducting fault current limiter 410 may comprise one or more low-inductance coils connected in series or parallel. The superconducting fault current limiter 410 may comprise one or more low-inductance coils for each phase of an electrical network to be protected.

### [Fifth embodiment]

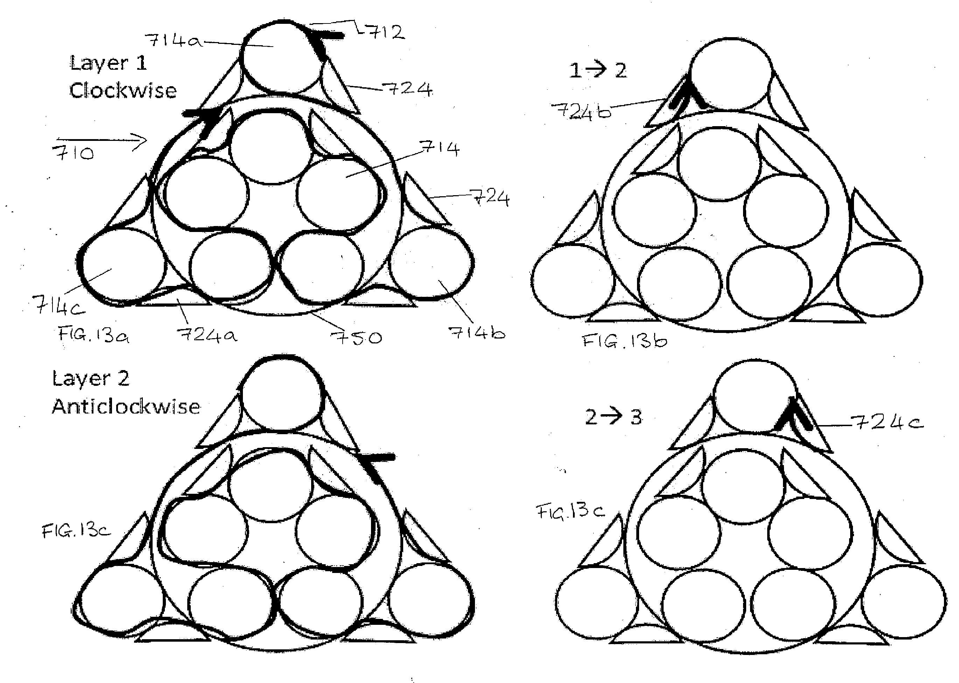

A fifth embodiment of the invention is shown in Figures 13a to 13d. A generally triangular arrangement 710 is formed by eight cylindrical formers 714 and eight part cylindrical supports 724, such that five of the cylindrical formers are arranged within the perimeter of a circle 750 and three of the formers 714 are arranged outside of the circle 750 such that their centres form the corners of an equilateral triangle. Referring firstly to Figure 13a, the coil 712 passes in an anti-clockwise sense around an outermost former 714a, clockwise around part of the periphery of the circle 750, in a clockwise sense around a second outermost former 714b, and then around part of the periphery of each of the formers 714 arranged within the circle 750, before passing around a part cylindrical support 724a and in a clockwise sense around the third outermost former 714c. The coil 712 then passes clockwise around part of the periphery of the circle 750. The coil 712 then passes around one of the part cylindrical supports 724b as shown in Figure 13b and then passes around the formers 714, 714a, 714b, 714c as shown in Figure 13c to form the next layer, i.e. in a manner which is a mirror image of the arrangement shown in Figure 13a. The coil 712 then passes around one of the part cylindrical guides 724c as shown in Figure 13d, and then the process shown in Figures 13a to 13d is repeated for subsequent layers. It can be seen that the path followed in Figure 13c has identical radii of curvature in each portion to corresponding parts of the path followed in Figure 13a, but in an opposite sense so that the magnetic field generated by each turn of one layer is substantially cancelled by the field generated in the subsequent layer.

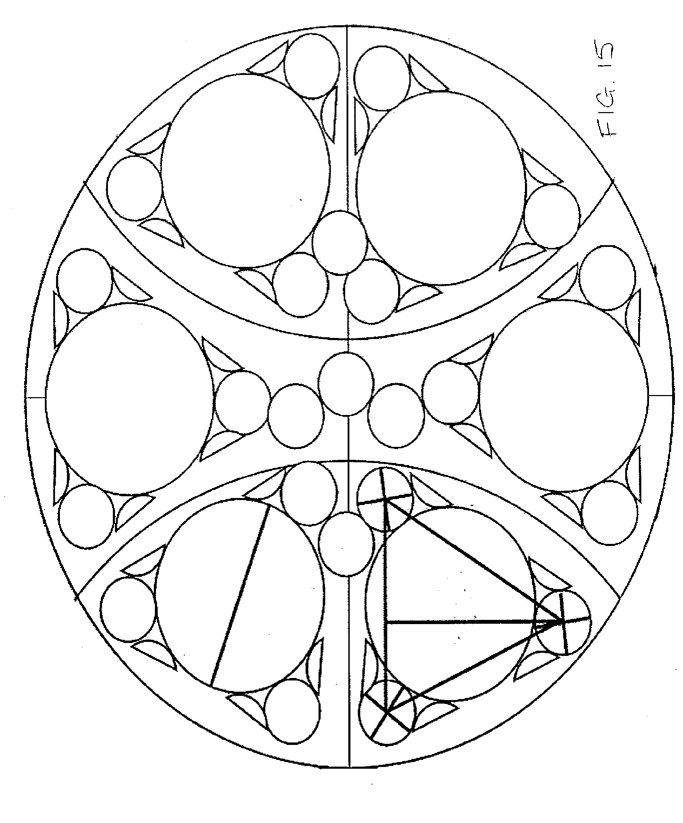

The arrangement shown in Figures 13a to 13d has the advantage that a very high packing density of the superconducting element 712 can be achieved, and the triangular arrangement of the turns enables the coil assemblies 710 to be easily inserted into a cylindrical tank of cryocoolant liquid. In particular, since the angle subtended by the apex of each triangular arrangement of turns is 60 degrees, this enables six arrangements of turns to be easily arranged in a cylindrical tank of coolant liquid such that there are two arrangements of turns for each phase, as shown in Figure 15.

### [Sixth embodiment]

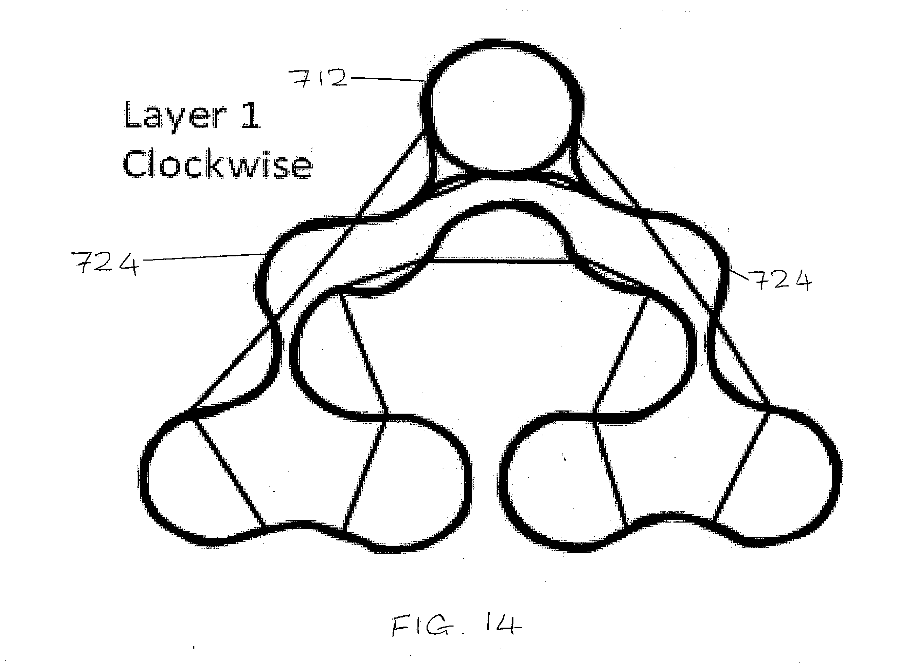

A further embodiment is shown in Figure 14, in which instead of following parts of the perimeter of the circle 750 within which five of the formers 714 are arranged, the coil 712 passes around further part cylindrical supports 724 having substantially the same radius of curvature as the formers 714.

It will be appreciated by persons skilled in the art that the above embodiments have been described by way of example only, and not in any limitative sense, and that various alterations and modifications are possible without departure from the scope of the invention as defined by the appended claims.

For example, although the present invention has been described in connection with superconducting fault current limiters, the coil according to the present invention may have other applications where a compact or low-inductance coil is required.

Although monofilar coils have been described, and have particular advantages over bifilar coils, any of the coils of the first to third embodiments may be wound as bifilar coils. In this case, the reversal of direction between the two strands of the bifilar winding could be implemented as a monofilar loop around one or more of the subcoils, the loop having a radius of curvature greater than a predetermined minimum radius of curvature. This would enable a bifilar coil to be wound more compactly using a continuous conducting element, avoiding the need for a connection between the two strands of the bifilar winding.

## Claims

1. A coil comprising an electrically conducting element defining:
a plurality of first turns around a first axis,
wherein at least two said first turns are adapted to carry a current in opposite senses around the first axis; and
a respective plurality of second turns around at least one second axis,
wherein at least two said second turns are adapted to carry a current in opposite senses around a respective said second axis;
wherein at least two said first turns are connected in series via at least one second turn.

2. A coil according to claim 1, wherein the ends of the conducting element are located at or extend from locations spaced apart along at least one said first or second axis.

3. A coil according to claim 1 or 2, wherein the conducting element comprises at least one super-conducting material.

4. A coil according to any one of the preceding claims, wherein at least one first turn is connected to at least one second turn by a portion of the conducting element.

5. A coil according to any one of the preceding claims, wherein at least one said plurality of first and/or second turns comprises a plurality of pairs of adjacent said first or second turns adapted to carry said current in opposite senses.

6. A coil according to any one of the preceding claims, wherein at least one said plurality of first and/or second turns comprises an equal number of turns in each sense about the respective first and/or second axis.

7. A coil according to any one of the preceding claims, wherein said first axis and at least one said second axis are substantially parallel.

8. A coil according to any one of the preceding claims, wherein the conducting element is wound in a figure-of-eight type pattern about said first and one said second axis.

9. A coil according to any one of the preceding claims, wherein a plurality of said first and/or second turns have a substantially constant radius of curvature.

10. A coil according to claim 9, wherein a plurality of said first and said second turns have a first radius of curvature and a plurality of said first and said second turns are arranged radially inward of the periphery of a circle having a second radius of curvature, larger than said first radius of curvature, and at least three said turns are arranged at separate locations radially outwards of the periphery of said circle.

11. A coil assembly, comprising:
a coil according to any one of the preceding claims; and
a plurality of formers;
wherein each said plurality of first and second turns is wound on a respective former.

12. A coil assembly according to claim 11, further comprising one or more supports for constraining the path of the conducting element between two or more formers.

13. A coil assembly according to claim 12, wherein at least one said support includes a support portion for engaging the conducting element and having a radius of curvature substantially equal to that of at least one said first and/or said second turn.

14. A superconducting fault current limiter, comprising:
at least one coil according to any one of claims 1 to 10, wherein the conducting element comprises a super-conducting material; and
at least one vessel adapted to enclose at least said superconducting element at a temperature below the critical temperature of the superconducting material.
